# EUROPEAN PATENT SPECIFICATION

(11) **EP 0 929 095 B1**
(45) Date of publication and mention of the grant of the patent: **15.09.2004**
(21) Application number: 98830007.5
(22) Date of filing: 13.01.1998
(51) Int. Cl.: H01L 21/00

(54) **Method for producing an SOI wafer**
Verfahren zur Herstellung eines SOI-Substrates
Procédé pour fabriquer un substrat du type SOI

(43) Date of publication of application: 14.07.1999
(73) Proprietor: STMicroelectronics S.r.l., 20041 Agrate Brianza (Milano) (IT)
(72) Inventor: Villa, Flavio, 20159 Milano (IT); Barlocchi, Gabriele, 20010 Cornaredo (IT)
(74) Representative: Cerbaro, Elena, Dr.

(56) References cited:
- EP-A- 0 488 344
- US-A- 4 760 036
- US-A- 4 948 456
- US-A- 5 115 289
- US-A- 5 208 167
- US-A- 5 635 411
- PATENT ABSTRACTS OF JAPAN vol. 018, no. 171 (E-1529), 23 March 1994 & JP 05 343320 A (ROHM CO LTD), 24 December 1993,

## Description

The present invention relates to a method for producing an SOI wafer.

As known, according to a solution currently very widespread in microelectronics industry, the substrate of integrated devices is obtained from wafers of monocrystalline silicon. In the last few years, as an alternative to wafers consisting of silicon alone, composite wafers, so-called "SOI" (Silicon-on-Insulator) wafers have been proposed, comprising two silicon layers, one of which is thinner than the other, separated by a silicon oxide layer (see for example the article "Silicon-on-Insulator Wafer Bonding - Wafer Thinning Technological Evaluations" by J. Hausman, G.A. Spierings, U.K.P. Bierman and J.A. Pals, Japanese Journal of Applied Physics, Vol. 28, No. 8, August 1989, pp. 1426-1443).

Considerable attention has recently been paid to SOI wafers, since integrated circuits having a substrate formed from wafers of this type have considerable advantages compared with similar circuits formed on conventional substrates, formed by monocrystalline silicon alone. These advantages can be summarised as follows:
a) faster switching speed;
b) greater immunity to noise;
c) smaller loss currents;
d) elimination of parasitic component activation phenomena (latch-up);
e) reduction of parasitic capacities;
f) greater resistance to radiation effects; and
g) greater component packing density.

A typical process for producing SOI wafers is described in the aforementioned article, and is based on bonding two monocrystalline silicon wafers (wafer bonding process). In particular, according to this process, one wafer is oxidised, and after cleaning operations, it is bonded to the other wafer; after a thermal annealing step, the outer surface of the oxidised wafer is submitted to surface grinding, polishing until the required thickness is obtained (for example 1 µm), and buffing. An epitaxial layer, integrating electronic components, is subsequently optionally grown on the thinner monocrystalline silicon layer.

The wafers obtained by the conventional wafer bonding method have excellent electrical features, but have undeniably high costs (approximately six times greater than the cost of the standard substrates).

Other methodologies, such as ZHR, SIMOX, etc., are described in the article "SOI Technologies: Their Past, Present and Future" by J. Haisha, Journal de Physique, Colloque C4, Supplément à no. 9, Tome 49, September 1988. These latter techniques have also not yet reached an acceptable industrial level, and have some limitations. In fact, they do not allow obtainment of monocrystalline silicon layers on extensive oxide areas, they have a high defect level owing to displacements generated by stresses induced by the covered oxide, or they do not allow application of high voltages as with SIMOX technology, wherein the oxide thickness obtained by oxygen implant is approximately 100-200 nm.

US-A-5 115 289 discloses a semiconductor device, such as an PET or a charge coupled device, having a channel or a charge coupled portion formed in a thin semiconductor layer which is substantially perpendicular to the substrate. Necessary electrodes, such as the gate electrode, and necessary insulating layers can be added at the thin semiconductor layer, and can maintain the necessary amount of electric current by securing the height of the semiconductor layer. The structure has the advantage that it can have its plane size reduced. Further, the semiconductor memory device using the above semiconductor device is suitable to high integration and has excellent electric characteristics.

US-A-4 760 036 discloses a process for growing silicon-on-insulator wafers in which complete isolation of the grown silicon from the substrate silicon by an intermediate oxide layer is obtained. A first epitaxial lateral overgrowth technique is used to grow a continuous layer of silicon through seed holes in a patterned oxide layer overlying the silicon substrate. Then the silicon layer is etched to expose the seed holes which are then oxidized to make the oxide layer aperture-free. This is followed by a second epitaxial lateral overgrowth step to replace the silicon etched in the silicon layer to make a merged, substantially planar layer.

US-A-5 208 167 discloses a method for producing a SOI substrate comprising a step of forming a first opening to an insulating film on a semiconductor substrate and then forming semiconductor crystal layer by epitaxial growth over the first opening and the insulating film; a step of forming a second opening by partially removing the semiconductor crystal layer; a step of forming an integrated insulating film, and a step of forming an integrated semiconductor crystal layer. In this way, a semiconductor crystal layer can be formed on an insulating film on a substrate with large area, wherein the crystal layer and the substrate is completely insulated from each other. Further even from such materials as hard to form monocrystal substrate, a substrate can be easily obtained.

The object of the invention is thus to provide an SOI wafer production method which exploits the inherent advantages of these technologies, but at competitive costs with respect to standard, fully monocrystalline substrates now used.

According to the present invention, an SOI wafer production method is provided, as defined in claim 1.

In order to help understanding of the present invention, a preferred embodiment is now described, purely by way of non-limiting example, with reference to the attached drawings, in which:
- figures 1-10 show cross-sections through an SOI wafer in successive production steps; and
- figures 11 and 12 show perspective cross-sections in two successive steps.

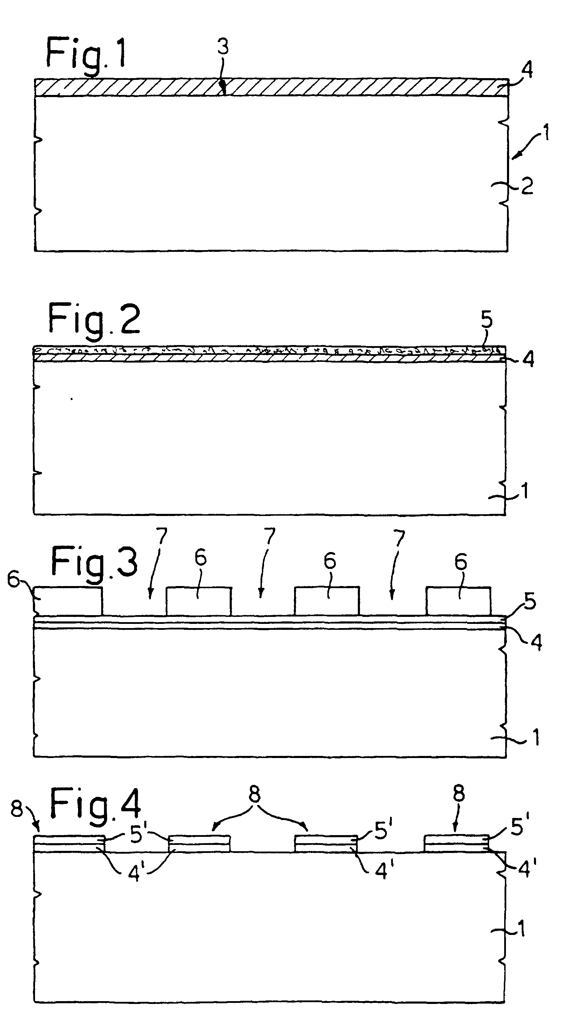

As shown in figure 1, a wafer, formed by a monocrystalline silicon region 2, is initially subjected to oxidation to grow, on one of its surfaces 3, a first silicon oxide layer 4, e.g. with a thickness of 200 to 600 Å.

Subsequently, on first oxide layer 4, a first silicon nitride layer 5 is deposited with a thickness of 900 to 1500 Å (figure 2); on first nitride layer 5, a resist layer is deposited, and the latter is etched such as to form a resist mask 6, comprising regions delimited by apertures 7, which leave uncovered selective portions of first nitride layer 5, figure 3. The apertures 7 are advantageously in the form of strips extending in a perpendicular direction to the sheet, are spaced from one another by approximately 1 µm, and have a width of 1 to 2 µm; alternatively they form a grid, and the regions forming resist mask 6 have any form, for example they can be square, rectangular, hexagonal or polygonal.

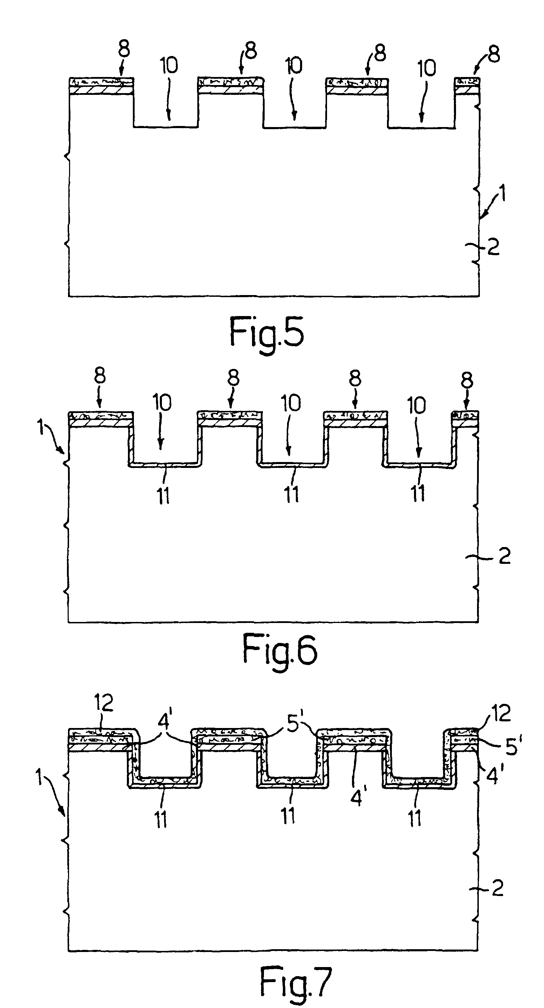

Using resist mask 6, uncovered portions of first nitride layer 5 and first oxide layer 4 are dry etched, leaving portions of these layers indicated at 5' and 4'; resist mask 6 is then removed, and the intermediate structure in figure 4 is obtained, in which remaining portions 4' and 5' form a hard mask, indicated at 8.

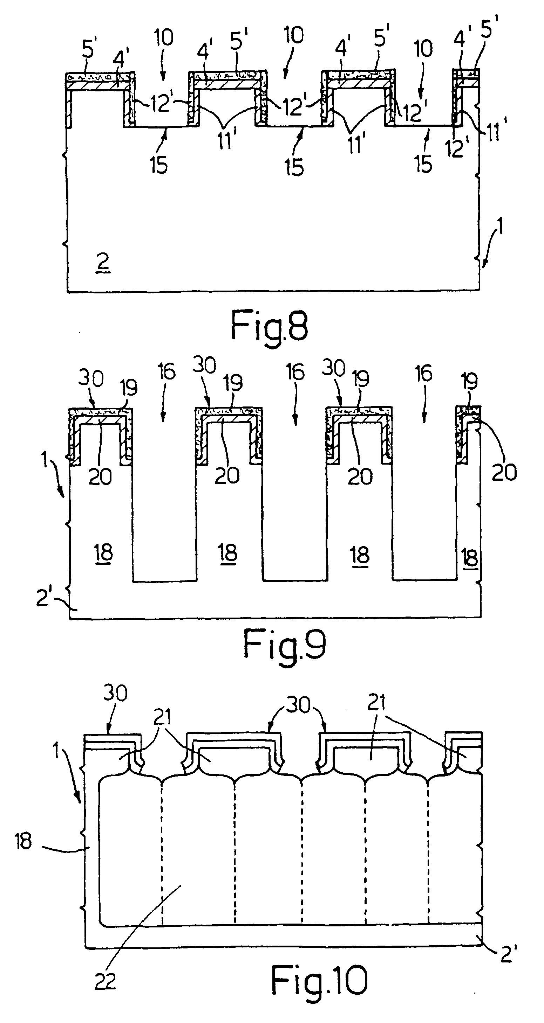

Using hard mask 8, monocrystalline silicon region 2 is then etched, forming initial trenches 10, the shape, width and spacing whereof corresponds to that of apertures 7, and the depth of which is 0.5 to 5 µm, depending on the required characteristics for the covered oxide layer to be produced, as explained hereinafter (figure 5). Subsequently, wafer 1 is submitted to oxidation, thus forming a second oxide layer 11 covering the walls and base of initial trenches 10 (figure 6). Second oxide layer 11 has a thickness of, for example, 200 to 600 Å. A second silicon nitride layer 12 is then deposited, with a thickness of 900 to 1500 Å (figure 7), and layers 12 and 11 are anisotropically etched without mask. Owing to anisotropy of etching, the horizontal portions are removed from second silicon nitride 12 and oxide 11 layers on the base of initial trenches 10, and above portions 4', 5', giving the intermediate structure in figure 8 wherein the monocrystalline silicon of region 2 is still covered by mask 8 (oxide 4' and nitride 5' portions) on the areas between initial trenches 10, and is covered by oxide 11' and nitride 12' portions on the vertical walls of initial trenches 10, and on the other hand is bare on base 15 of initial trenches 10.

The uncovered silicon is then etched at base 15 of initial trenches 10, in order to deepen initial trenches 10 until final trenches or recesses 16 of the required depth are obtained. In particular, the depth of final trenches 16 (like that of initial trenches 10) determines the dimensions of the required covered oxide layer, and thus the electrical characteristics of the SOI wafer, as explained hereinafter, and it is therefore determined on the basis of the specifications provided for the final SOI wafer. Monocrystalline silicon region now comprises a base portion indicated at 2', and a plurality of "columns" 18, extending vertically from base portion 2', the shape whereof corresponds substantially to that of resist region 6 in figure 3. This thus provides the intermediate structure of figure 9, wherein nitride portions 5' and 12' are no longer separated from each other and are indicated at 19, and oxide portions 4' and 11' are no longer separated from each other, are indicated at 20, and, together with portions 19, form protective regions 30.

An oxidation step is then carried out, such that the exposed silicon regions of "columns" 18 are transformed into silicon oxide. In practice, there is gradual growth of oxide regions, to the detriment of silicon regions, starting from lateral walls of final trenches 16, towards the interior of the columns, and partly also towards and inside base portions 2'. Since during oxidation there is an increase in volume, the oxide regions being formed gradually occupy the space of the final trenches 16, until they close the latter completely and join to another. The oxidation step ends automatically when columns 18 have been completely oxidised (apart from the upper area or tip, indicated at 21, which is protected by protective regions 30), forming a continuous covered oxide region 22, shown in figure 10, wherein broken lines indicate the contacting surfaces of the oxide regions being formed from walls of two adjacent final trenches 16, to show the oxide growing phenomenon. The form of covered oxide region 22, which is now forming a continuous layer, can be regulated in a known manner by previously carrying out angle implantation (after creation of the final trenches 16), such as to obtain during oxidation a high volume growth for doped regions, which is greater than in case of intrinsic regions (concerning this technique, see for example the article "Trench Sidewall Implantation with a Parallel Scanned Ion Beam" by R. Kakoschke, R.E. Kaim, P.F.H.M. Van Der Meulen, J.F.M. Westendorp, IEEE Trans. Elec. Dev., Nov. 1989). In addition to, or as an alternative to angle implantation, the form of oxide can also be regulated by using a buffered local oxidation step (poly-buffered LOCOS, as described for example in the text "Smart Power ICs - Technologies and Applications" by B. Murari, F. Bertotti, G.A. Vignola, Springer, page 21, fig. 1.21), i.e. by depositing two polysilicon layers between layers 11 and 12, when forming a polycrystalline silicon region between oxide portions 20 and nitride portions 19. Thus, the structure of figure 10 is obtained, wherein only a portion of column 18 remains furthest to the left, ending in an upper portion, indicated at 21 for the sake of uniformity.

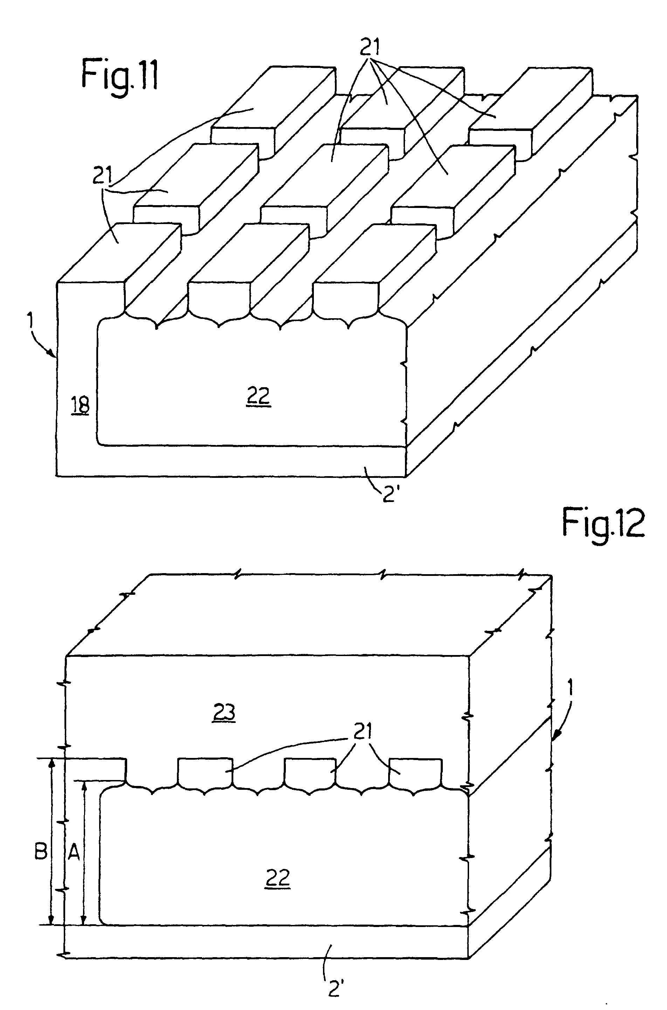

Subsequently, by selective etching, protective regions 30 are eliminated such as to uncover "tips" 21 which are intended to form the nuclei for a subsequent epitaxial growth step. The structure of figure 11 is obtained, which shows the three-dimensional structure of wafer 1 in this step, for a grid-shaped mask 6, as already described with reference to figure 3. Subsequently, epitaxial growth is carried out, the parameters of which are selected such as to prevent nucleation of silicon in the areas above oxide region 22, and a high ratio of lateral to vertical growth is selected, such as to obtain initially horizontal growth of silicon around tips 21, and thus covering of the upper surface of covered oxide region 22, and then vertical growth of an epitaxial layer 23. After an optional chemical-mechanical polishing step (as described for example in the article "Chemical Mechanical Polishing for Polysilicon Surface Micromachining" by A.A. Yasseen, N.J. Mourlas and M. Mehregany, J. Electrochem. Soc. vol. 144, No. 1, Jan. 1997), in order to level the upper surface of wafer 1, the final structure of the wafer 1 shown in figure 12 is then obtained.

subsequently, for example during production of electronic components, heat treatment steps can be carried out to eliminate stresses induced by covered oxide.

In the structure of figure 12, the dimensions A (thickness of covered oxide region 22) and B (depth of covered oxide region relative to upper monocrystalline region formed by epitaxial layer 23 and "tips" 21) can be regulated within extensive limits, by modifying the depth of initial trenches 10 (and thus the depths of the vertical walls of protective regions 30), and of final trenches 16, since the depth of the covered oxide layer depends on the depth of the final trenches, and the difference between the depths of final trenches 16 and that of initial trenches 10 determines the thickness of the covered oxide layer. Thereby, in case of A<B, it is possible to obtain a thick oxide layer, and, in the case of A>>B, a thin, deep oxide layer.

The resulting wafer can advantageously be used for producing integrated micro-electronic circuits, sensors of different types (e.g. pressure, gas, temperature etc.), and micro-integrated mechanical structures such as gyroscopes, micromotors and so on.

The advantages of the described method are immediately apparent from the preceding description. In particular, it is emphasised that the described method produces a covered oxide layer using only process steps which are well known and already in use in integrated circuit production, with costs which are much lower than those of the processes currently used for production of SOI substrates.

In addition, as indicated, it is possible to adapt the dimensions and thus the electrical features of SOI wafer to specific applications, similarly to known SOI processes.

Finally, it is apparent that many modifications and variants can be made to the described and illustrated method, all of which come within the scope of the invention, as defined in the attached claims. In particular it is stressed that the deep oxide region can cover all, or virtually all, wafer 1, forming a complete layer, or it can extend to only one or a plurality of predetermined wafer areas, in order to form a selective SOI substrate, on the basis of the requirements of the components to be integrated in the epitaxial layer or the final structure to be obtained from the substrate. In addition, it is stressed that the shape of mask 6, and thus of monocrystalline silicon regions which are subjected to oxidation to form covered oxide layers, can vary, as indicated above.

## Claims

1. An SOI wafer production method, **characterised in that** it comprises, in sequence, the steps of:
- on a wafer (1) of monocrystalline semiconductor material, forming protective regions (30) of an oxidation resistant material, covering first wafer portions (18);
- forming deep trenches (16) in second wafer portions not covered by said protective regions (30), extending between and laterally delimiting said first wafer portions (18);
- oxidising completely said first wafer portions (18) laterally delimited by said deep trenches (16), except upper portions (21) of said first wafer portions (18), forming at least one continuous buried oxide region (22) overlaid by said non-oxidised upper portions (21) covered by said protective regions (30);
- removing said protective regions (30); and
- epitaxially growing a crystalline semiconductor material layer (23) from said non-oxidised upper portions (21).

2. A method according to claim 1, **characterised in that** said protective regions (30) have the shape of an overturned U.

3. A method according to claim 2, **characterised in that** said step of forming said protective regions (30) comprises the steps of:
- forming a mask (8) of said oxidation resistant material, on an upper surface (3) of said first wafer portions (18);
- excavating said second wafer portions which are not covered by said mask (8), such as to form initial trenches (10) extending between said first wafer portions (18);
- forming vertical lateral protective walls (11', 12') of non-oxidisable material laterally covering said non-oxidised upper portions (21), and forming, with said mask (8), said overturned U shape.

4. A method according to claim 3, **characterised in that** said step of forming a mask (8) comprises the steps of forming a first oxide layer (4); depositing a first nitride layer (5) on said first oxide layer; and removing selective portions of said first oxide and nitride layers (4, 5).

5. A method according to claim 3 or claim 4, **characterised in that** said step of forming vertical lateral protective walls (11', 12') comprises the steps of: forming a second oxide layer (11) covering said mask (8), base walls and said lateral walls of said initial trenches (10); depositing a second nitride layer (12) on said second oxide layer (11); and anisotropically etching said second oxide and nitride layers.

6. A method according to any one of the preceding claims, **characterised in that** said deep trenches (16) extend along parallel strips.

7. A method according to any one of claims 1 to 5, **characterised in that** said deep trenches (16) form a grid.

8. A method according to any one of the preceding claims, **characterised in that** before said oxidation step, the step is carried out of angle implanting doping ionic species.

9. A method according to any one of the preceding claims, **characterised in that** said step of forming protective regions (30) comprises the step of forming local oxide regions buffered with polycrystalline silicon.

## Patentansprüche

1. SOI-Wafer- bzw. Substrat-Herstellungsverfahren, **dadurch gekennzeichnet, dass** es aufeinanderfolgend die Schritte aufweist:
- Bilden von Schutzbereichen (30) aus einem gegen Oxydation resistenten Material, welche erste Wafer-Bereiche (18) bedecken, auf einem Wafer (1) aus monokristallinem Halbleitermaterial;
- Bilden von tiefen Gräben (16) in zweiten Wafer-Bereichen, welche nicht durch die Schutzbereiche (30) bedeckt sind, welche sich dazwischen erstrecken und welche die ersten Wafer-Bereiche (18) begrenzen;
- vollständiges Oxydieren der ersten Wafer-Bereiche (18), welche lateral durch die tiefen Gräben (16) begrenzt sind, ausser den oberen Bereichen (21) der ersten Wafer-Bereiche (18), wobei wenigstens ein kontinuierlich vergrabener bzw. eingebetteter Oxydschicht-Bereich (22) entsteht, welcher von den nicht-oxydierten oberen Bereichen (21) überdeckt wird, welche durch die Schutzbereiche (30) bedeckt sind;
- Entfernen der Schutzbereiche (30); und
- epitaxiales Wachsenlassen bzw. Züchten einer kristallinen Halbleitermaterialschicht (23) aus diesen nicht-oxydierten oberen Bereichen (21).

2. Verfahren nach Anspruch 1, **dadurch gekennzeichnet, dass** die Schutzbereiche (30) die Form eines umgedrehten "U" besitzen.

3. Verfahren nach Anspruch 2, **dadurch gekennzeichnet, dass** der Schritt des Bildens der Schutzbereiche (30) die Schritte aufweist:
- Bilden einer Maske (8) aus dem gegen Oxydation resistenten Material, auf einer Oberen Oberfläche (3) der ersten Wafer-Bereiche (18);
- Aushöhlen der zweiten Wafer-Bereiche, welche nicht durch die Maske (8) abgedeckt sind, um so Ausgangsgräben (10) zu bilden, welche sich zwischen den ersten Wafer-Bereichen (18) erstrecken;
- Bilden vertikaler lateraler schutzwände (11',12') aus nichtoxydierbarem Material, welche die nichtoxydierten oberen Bereiche (21) abdecken, und Bilden der umgekehrten "U"-Form mit der Maske (8).

4. Verfahren nach Anspruch 3, **dadurch gekennzeichnet, dass** der Schritt des Bildens einer Maske (8) die Schritte des Bildens einer ersten Oxydschicht (4); Aufbringen einer ersten Nitridschicht (5) auf der ersten Oxydschicht; und Entfernen ausgewählter Bereiche der ersten Oxyd- und Nitridschichten (4,5) aufweist.

5. Verfahren nach Anspruch 3 oder 4, **dadurch gekennzeichnet, dass** der Schritt des Bildens vertikaler lateraler Schutzwände (11',12') die Schritte aufweist: Bilden einer zweiten Oxydschicht (11), welche die Maske (8), die Grundwände und die lateralen Wände der Ausgangsgräben (10) abdeckt; Aufbringen einer zweiten Nitridschicht (12) auf der zweiten Oxydschicht (11), und anisotropes Ätzen der zweiten Oxyd- und Nitridschichten.

6. Verfahren nach einem der vorausgehenden Ansprüche, **dadurch gekennzeichnet, dass** sich die tiefen Gräben (16) entlang paralleler Streifen erstrecken.

7. Verfahren nach einem der Ansprüche 1 bis 5 **dadurch gekennzeichnet, dass** die tiefen Gräben (16) ein Gitter bilden.

8. Verfahren nach einem der vorausgehenden Ansprüche, **dadurch gekennzeichnet, dass** vor dem Oxydationsschritt, der Schritt des Winkelimplantierens einer ionischen Dotier-Spezies ausgeführt wird.

9. Verfahren nach einem der vorausgehenden Ansprüche, **dadurch gekennzeichnet, dass** der Schritt des Bildens von Schutzbereichen (30) den Schritt des Bildens lokaler Oxyd-Bereiche aufweist, welche mit polykristallinem Silizium gepuffert sind.

## Revendications

1. Procédé de production de tranche de SOI, **caractérisé en ce qu'**il comprend, en séquence, les étapes consistant à :
- sur une tranche (1) de matériau semi-conducteur monocristallin, former des régions de protection (30) en un matériau résistant à l'oxydation, recouvrant des premières parties de tranche (18) ;
- former des tranchées profondes (16) dans des secondes parties de tranche non recouvertes par lesdites régions de protection (30), s'étendant entre lesdites premières parties de tranche (18) et délimitant latéralement ces dernières ;
- oxyder complètement lesdites premières parties de tranche (18) délimitées latéralement par lesdites tranchées profondes (16), à l'exception de parties supérieures (21) desdites premières parties de tranche (18), formant au moins une région d'oxyde enfouie continue (22) recouverte par lesdites parties supérieures non oxydées (21) couvertes par lesdites régions de protection (30) ;
- enlever lesdites régions de protection (30) ; et
- faire croître de manière épitaxiale une couche de matériau semi-conducteur cristallin (23) à partir desdites parties supérieures non oxydées (21).

2. Procédé selon la revendication 1, **caractérisé en ce que** lesdites régions de protection (30) ont la forme d'un U renversé.

3. Procédé selon la revendication 2, **caractérisé en ce que** ladite étape de formation desdites régions de protection (30) comprend les étapes consistant à :
- former un masque (8) dudit matériau résistant à l'oxydation, sur une surface supérieure (3) desdites premières parties de tranche (18) ;
- dégager lesdites secondes parties de tranche qui ne sont pas recouvertes par ledit masque (8), de façon à former des tranchées initiales (10) s'étendant entre lesdites premières parties de tranche (18) ;
- former des parois de protection verticales latérales (11', 12') de matériau non oxydable couvrant latéralement lesdites parties supérieures non oxydées (21), et former, à l'aide dudit masque (8), ladite forme de U renversé.

4. Procédé selon la revendication 3, **caractérisé en ce que** ladite étape de formation d'un masque (8) comprend les étapes consistant à former une première couche d'oxyde (4) ; déposer une première couche de nitrure (5) sur ladite première couche d'oxyde ; et enlever des parties sélectives desdites premières couches d'oxyde et de nitrure (4, 5).

5. Procédé selon la revendication 3 ou la revendication 4, **caractérisé en ce que** ladite étape de formation de parois de protection verticales latérales (11', 12') comprend les étapes consistant à : former une seconde couche d'oxyde (11) recouvrant ledit masque (8), les parois de base et lesdites parois latérales desdites tranchées initiales (10) ; déposer une seconde couche de nitrure (12) sur ladite seconde couche d'oxyde (11) ; et graver de façon anisotrope lesdites secondes couches d'oxyde et de nitrure.

6. Procédé selon l'une quelconque des revendications précédentes, **caractérisé en ce que** lesdites tranchées profondes (16) s'étendent le long de bandes parallèles.

7. Procédé selon l'une quelconque des revendications 1 à 5, **caractérisé en ce que** lesdites tranchées profondes (16) forment une grille.

8. Procédé selon l'une quelconque des revendications précédentes, **caractérisé en ce que**, avant ladite étape d'oxydation, l'étape est réalisée en implantant en angle des espèces ioniques dopantes.

9. Procédé selon l'une quelconque des revendications précédentes, **caractérisé en ce que** ladite étape de formation de régions de protection (30) comprend l'étape de formation de régions d'oxyde locales tamponnées avec du silicium polycristallin.
